# FASCICULE DE BREVET EUROPEEN

(11) **EP 0 762 259 B1**
(45) Date de publication et mention de la délivrance du brevet: **04.08.1999**
(21) Numéro de dépôt: 96401854.3
(22) Date de dépôt: 29.08.1996
(51) Int. Cl.: G05F 3/26

(54) **Circuit de polarisation destiné à fixer le niveau moyen d'une tension alternative**
Vorspannungsschaltung zur Stellung des durchschnittlichen Pegels einer alternierenden Spannung
Bias circuit for setting the average level of an alternating voltage

(30) Priorité: 31.08.1995 FR 9510262
(43) Date de publication de la demande: 12.03.1997
(73) Titulaire: C.S.E.M. CENTRE SUISSE D'ELECTRONIQUE ET DE MICROTECHNIQUE SA, 2007 Neuchâtel (CH)
(72) Inventeur: Aebischer, Daniel, 2000 Neuchatel (CH)
(74) Mandataire: Caron, Gérard

(56) Documents cités:
- EP-A- 0 570 820
- US-A- 4 814 644
- US-A- 5 113 129

## Description

La présente invention est relative au domaine des circuits intégrés comportant un circuit de polarisation destiné à fixer le niveau continu moyen d'une tension alternative, en particulier sinusoïdale.

Plus particulièrement, l'invention concerne un circuit d'interface entre une source de tension alternative à niveau continu moyen aléatoire, et un circuit récepteur nécessitant pour fonctionner une tension alternative dont le niveau continu moyen doit être fixé.

Un tel circuit d'interface peut être utilisé notamment avec un oscillateur à quartz par exemple qui doit faire partie d'un générateur de signal rectangulaire à rapport cyclique précisément déterminable. En effet, dans un tel cas, le rapport cyclique du signal à engendrer dépend directement du niveau moyen de la tension alternative qui sert à générer le signal rectangulaire.

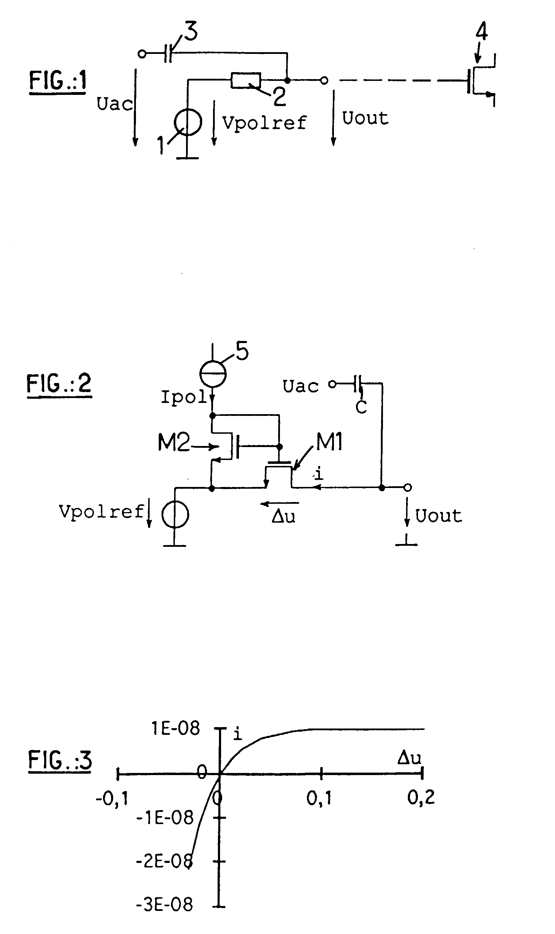

La figure 1 des dessins annexé montre un montage bien connu permettant d'obtenir un circuit d'interface du genre indiqué ci-dessus. Ce montage comprend une source de tension 1 fournissant une tension de polarisation V_{polref} et connectée en série avec une résistance 2 et un condensateur 3. La tension d'entrée U_{ac} de niveau moyen aléatoire est appliquée aux bornes du montage, tandis que la tension de sortie Uₒᵤₜ de niveau moyen déterminable avec précision, apparaît au point commun entre la résistance 2 et le condensateur 3. La tension Uₒᵤₜ est appliquée à un circuit d'utilisation symbolisé ici par le transistor 4.

Ce montage a l'avantage de la simplicité, mais il présente néanmoins certains inconvénients.

Tout d'abord, la résistance 2 constitue une charge pour la tension alternative. Suivant la résistance interne de la source de la tension d'entrée U_{ac} et la fréquence de coupure du dispositif, déterminée notamment par le condensateur 3, ce montage introduit un affaiblissement de l'amplitude et un déphasage indésirable du signal utile.

Par ailleurs, pour certains dispositifs tels que les oscillateurs à quartz, la résistance 2 introduit des pertes ohmiques et entraîne une diminution du facteur de qualité global, ce qui n'est souhaitable, ni pour la consommation, ni pour la stabilité en fréquence. Pour réduire ces phénomènes préjudiciables, il faut une résistance de valeur élevée ou utiliser une inductance.

Or, dans un circuit intégré, on ne dispose pas toujours de la possibilité de réaliser une résistance élevée, de l'ordre de plusieurs MΩ par exemple, sous peine d'occuper une place considérable sur la puce du circuit intégré. Elle peut également avoir une capacité parasite importante et induire une conductance de fuite, par exemple vers le substrat du circuit. De plus dans certains cas, elle n'est pas linéaire.

Pour tenter de remédier aux problèmes liés à l'utilisation d'une résistance, il a déjà été proposé d'utiliser à la place de la résistance un ou plusieurs composants actifs et notamment des transistors.

La figure 2 des dessins annexés montre un exemple d'un tel circuit. A la place de la résistance 2 du montage de la figure 1, ce circuit connu comporte un transistor M1 dans lequel circule un courant i et aux bornes duquel apparaît une chute de tension Δu. La valeur de la résistance équivalente R formée par le transistor M1 peut être déterminée à l'aide d'un second transistor M2 qui reçoit un courant Iₚₒₗ d'une source de courant constant 5. La grille de ce transistor de commande M2 est reliée à celle du transistor M1 et à sa propre source.

Dans ce cas, la résistance équivalente R peut donc être déterminée, pour une tension d'entrée U_{ac} donnée, en choisissant convenablement le courant Iₚₒₗ et les dimensions des transistors M1 et M2.

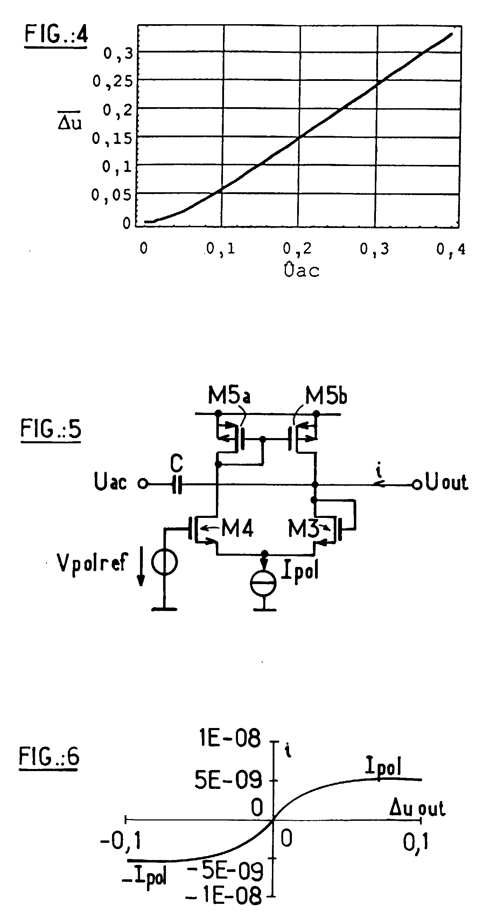

Cependant, ce montage présente un problème majeur qui réside dans le fait que la caractéristique courant-tension i=f(Δu) du transistor M1 n'est pas linéaire, comme le montre le graphique de la figure 3 des dessins annexés. La figure 3 montre cette caractéristique pour une tension de grille V_{g} déterminée du transistor M1. La figure 4 qui représente la relation entre la tension Δu moyenne en fonction de la tension de crête Û_{ac}, montre que le décalage du niveau continu moyen de la tension Û_{ac} est fortement croissant avec l'amplitude de cette dernière, de sorte qu'il subsiste une distorsion gênante (ici dans le sens positif) de ce niveau.

On connaît déjà un circuit présentant une caractéristique de transfert symétrique. Un tel montage est représenté sur la figure 5 des dessins annexés. Le montage comprend une paire différentielle, constituée par les transistors M3 et M4, alimentée à travers les transistors M5a et M5b, montés en miroir de courant. La grille du transistor M4 est reliée à la sortie d'une source de tension (V_{polref}) et celle du transistor M3 est reliée à la sortie (Uₒᵤₜ). Les sources des transistors M3 et M4 sont reliées à une source de courant (Iₚₒₗ). Le circuit constitue un amplificateur à transconductance, qui est utilisé comme résistance équivalente. Toute différence de tension entre les grilles des transistors M3 et M4 engendre un courant i. Ce circuit permet d'obtenir une courbe i=f(Δu), montrée à la figure 6, symétrique de part et d'autre de l'axe des ordonnées et donc, en principe, de maintenir le niveau continu moyen de la tension Uₒᵤₜ à une valeur stable.

L'inconvénient de ce circuit connu réside dans le fait que la symétrie de la courbe ne peut être obtenue que si le régime est quasi statique, c'est-à-dire pour une fréquence inférieure à une fréquence prédéterminée, car alors les potentiels des noeuds, formés par les sources des transistors M3 et M4 et par la grille du transistor M5a, ont le temps de s'établir complètement.

En revanche, si on souhaite réaliser une résistance équivalente élevée, ou si on veut réduire au minimum la consommation, le courant de polarisation Iₚₒₗ doit être faible alors que les capacités parasites du circuit auront une influence de plus en plus sensibles. C'est pourquoi au delà d'une certaine fréquence, la caractéristique de la figure 6 perd sa symétrie et il se crée donc, comme dans le cas précédent de la figure 2, un décalage de niveau par rapport au niveau nominal que l'on souhaite obtenir.

Il est à noter que ce décalage de tension ne peut que difficilement être contrôlé, car il dépend des capacités parasites, de la fréquence du signal U_{ac} et des niveaux des courants.

L'invention a pour but de fournir un circuit de polarisation destiné à fixer le niveau moyen d'une tension alternative qui soit dépourvu des inconvénients des circuits de la technique antérieure.

L'invention a donc pour objet un tel circuit comprenant le montage en série d'un élément capacitif et d'un composant actif formant résistance équivalente, une source de courant continu raccordée à ce composant actif et des moyens pour ajuster la conductance dudit composant actif et fixer ainsi le niveau moyen de ladite tension alternative, celle-ci étant appliquée aux bornes de ce montage en série, tandis que la tension polarisée ayant ledit niveau moyen est prélevée sur le noeud entre ledit élément capacitif et ledit composant actif, ce circuit étant caractérisé en ce qu'il comprend également des moyens pour moduler le courant continu traversant ledit composant actif avec une fraction de ladite tension alternative à polariser.

Grâce à ces caractéristiques, on peut éliminer de la tension polarisée tout défaut dû à la caractéristique de transfert non linéaire du composant actif, et ce pour des fréquences de fonctionnement du circuit supérieures à une fréquence prédéterminée.

D'autres caractéristiques et avantages de l'invention apparaîtront au cours de la description qui va suivre, donnée uniquement à titre d'exemple et faite en se référant aux dessins annexés sur lesquels:
- les figures 1 à 6 déjà décrites montrent par des schémas et des graphiques plusieurs solutions de la technique antérieure;
- la figure 7 représente le schéma d'un premier mode de réalisation du circuit de polarisation selon l'invention;
- la figure 8 représente un graphique courant/tension illustrant le fonctionnement du circuit de la figure 7;
les figures 9 à 13 montrent d'autres modes de réalisation du circuit de polarisation selon l'invention.

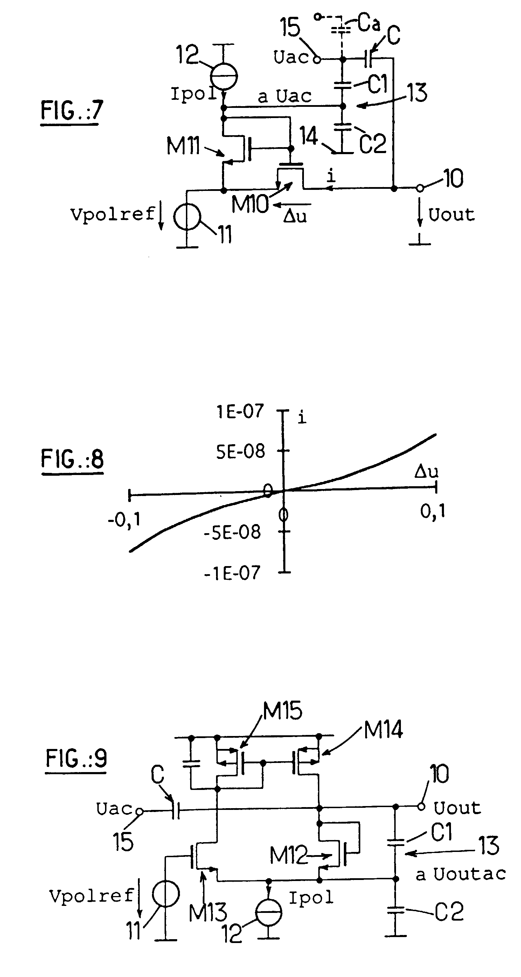

On a représenté sur la figure 7 un premier mode de réalisation de l'invention selon lequel le circuit de polarisation comprend un transistor M10 agissant comme résistance équivalente et dont le drain est connecté à la sortie 10 du circuit et également à un condensateur C. La source de ce transistor M10 est reliée à une source 11 d'une tension de polarisation v_{polref} et également à la source d'un autre transistor M11. La grille du transistor M10 est connectée à la fois à celle du transistor M11 et au drain de celui-ci. Le transistor M10 conduit un courant i et provoque une chute de tension Δu entre ses bornes de source et de drain.

Le circuit de polarisation comprend également une source de courant 12 débitant un courant de polarisation Iₚₒₗ dans le transistor M11.

Selon l'invention, le circuit comprend des moyens permettant d'imposer l'amplitude et la forme de la tension alternative du signal à polariser sur au moins l'un des noeuds du circuit, autrement dit de moduler le courant i traversant le transistor M10.

Dans le circuit de la figure 7, ces moyens sont formés par un diviseur capacitif de tension 13 comprenant deux condensateurs en série C1 et C2. Ce diviseur est relié entre la masse 14 du circuit et son entrée 15 à laquelle est appliquée la tension alternative à polariser. Le noeud entre les condensateurs C1 et C2 est connecté au noeud entre la source de courant 12 et le transistor M11.

Selon une variante de ce circuit, le condensateur C, (référencé Ca et représenté en pointillés sur la figure 7), peut être connecté entre la borne d'entrée et le diviseur 13, au lieu de l'être entre ce diviseur et la borne de sortie 10. Dans ce cas, le point commun au condensateur Ca et au condensateur C1 est connecté à la borne 10.

Dans le circuit que l'on vient de décrire, les tensions alternatives de tous les noeuds sont fixés par les capacités des condensateurs du diviseur de tension 13 et notamment celle de la grille du transistor M10. Ces tensions ne sont donc pas influencées par les conductances des divers composants, comme celles des transistors M10 et M11. Ainsi, il est possible d'utiliser des courants de polarisation continus très faibles créant des conductances également très faibles dans les éléments actifs. Ces composants chargent donc très peu les sources de tension non seulement continue mais également alternative.

En modulant ainsi la grille du transistor M10 en même temps que son drain, on obtient une caractéristique de transfert du transistor M10 dont la forme résulte de la figure 8. On voit que par rapport à la caractéristique de la figure 4, cette courbe prend une allure dynamique avec une très bonne symétrie vis-à-vis des axes. Il est à noter qu'à cet égard on n'a pas à considérer les composantes capacitives du courant i, car elles sont nulles en moyenne et elles n'interviennent donc pas dans l'élaboration des tensions continues moyennes.

Une autre propriété remarquable du circuit selon l'invention consiste en ce que, contrairement aux circuits de l'art antérieur décrits ci-dessus, le bon fonctionnement du circuit peut être garanti à partir d'une certaine fréquence minimale.

Le choix entre la configuration de circuit utilisant le condensateur C et celle utilisant le condensateur Ca dépend des capacités parasites associées aux capacités fonctionnelles du circuit, des grandeurs relatives de ces capacités, des charges admissibles à l'entrée 15 et à la sortie 10 et de l'affaiblissement que l'on peut tolérer au niveau de la sortie 10.

Le rapport du diviseur de tension 13 peut être choisi en fonction des besoins. Avantageusement, en utilisant un réseau de condensateurs sur le circuit intégré, on peut rendre ce rapport réglable par des techniques classiques de programmation. Par conséquent, la fonction Δ_{Umoyen} = f(Û_{ac}) devient programmable.

Le circuit de polarisation selon le mode de réalisation de l'invention représenté à la figure 9, est du type différentiel. Dans ce cas, le circuit comprend une paire de transistors M12 et M13 de type N et une autre paire de transistors M14 et M15 de type P, le transistor M12 formant la résistance équivalente R. La source de courant 12 fournissant le courant Iₚₒₗ est connectée aux sources des transistors M12 et M13 auxquelles est également relié le point milieu du diviseur capacitif 13. La source 11 de tension de référence V_{polref} est connectée à la grille du transistor M13. Les deux transistors M14 et M15 sont respectivement connectés en série avec les transistors M12 et M13. Le noeud entre les transistors M12 et M14 constitue la borne de sortie 10 du circuit, tandis que cette borne de sortie est reliée à la borne d'entrée 15 par l'intermédiaire du condensateur C.

Le circuit de la figure 9 présente l'avantage de nécessiter une plus faible tension d'alimentation que dans le cas de la figure 7 pour la même tension V_{polref}.

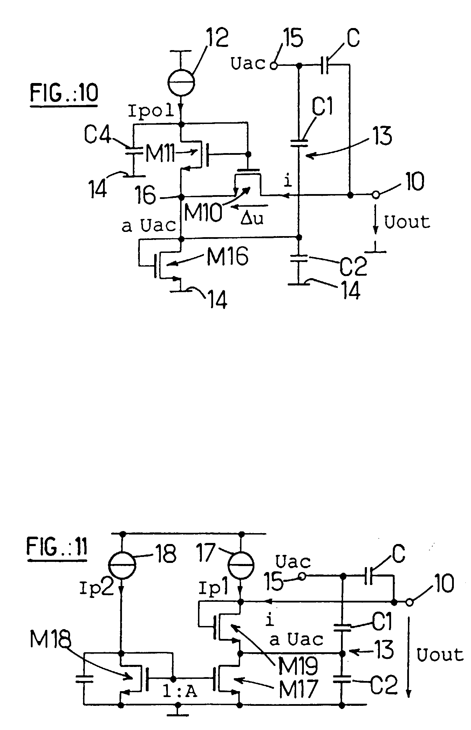

Le circuit de la figure 10 est une variante du circuit de la figure 7 dans laquelle le noeud 16 entre les transistors M10 et M11 est raccordé au drain d'un troisième transistor M16 qui est également connecté au point milieu du diviseur de tension 13. Par ailleurs, ce transistor M16 est connecté en série avec le transistor M11. Ce montage en série est connecté en parallèle à un condensateur C4. Dans ce cas, la tension de polarisation v_{polref} est "implicite" et proche de la tension de seuil des transistor MOS N.

Le circuit de polarisation selon le mode de réalisation de la figure 11 comporte un miroir de courant composé des transistors M17 et M18. Le transistor M19 fait office de résistance équivalente. Le noeud entre les transistors M18 et M19 est ici connecté au point milieu du diviseur de tension 13. Chacune des branches du circuit comprend une source de courant, resp. 17 et 18. Le courant dans le transistor M9 est déterminé par la source de courant Iₚ₁. Le miroir de courant sert à maintenir le potentiel continu moyen du noeud 13 à une valeur proche de zéro.

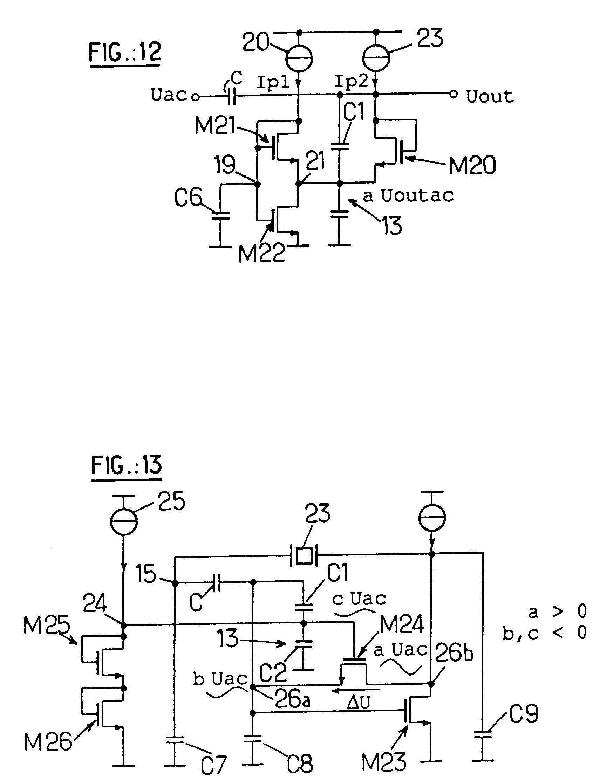

Le circuit de polarisation selon le mode de réalisation de la figure 12 comprend un transistor M20 faisant office de résistance équivalente et deux autres transistors M21 et M22 reliés en série et dont les grilles forment un noeud commun 19 qui est relié à travers un condensateur C6 à la masse. Ce noeud 19 est également connecté à une première source de courant 20 débitant dans le montage en série des transistors M21 et M22.

Le noeud 21 entre le drain et la source respectifs des transistors M21 et M22 est relié au point milieu du diviseur capacitif 13. Une seconde source de courant 23 débite dans le transistor M20.

La figure 13 montre un autre mode de réalisation du circuit de polarisation dans le cadre de son utilisation dans un oscillateur à quartz.

Ce montage comporte un quartz 23 connecté à un transistor M23. Ce montage comprend également un transistor M24 faisant office de résistance équivalente. La grille de ce transistor M24 est connectée au point milieu du diviseur capacitif 13 et également à un noeud de polarisation 24 qui est le point de jonction entre une source de courant 25 et deux transistors de polarisation M25 et M26 montés en série. La grille du transistor M23 est connectée à un noeud 26a situé entre les condensateurs C et C1. Ce noeud est à une tension qui est en opposition de phase par rapport au noeud 26b entre les transistors M23 et M24. Par ailleurs, des condensateurs C7, C8 et C9 sont connectés entre la masse et les noeuds respectifs 15, 25 et 10.

Grâce à l'invention, il est donc possible d'imposer avec une bonne précision la valeur de la composante continue d'une tension alternative ou d'une différence de tensions alternatives, sans que l'on doive utiliser des résistances ohmiques à cet effet.

Pour une amplitude donnée de la tension d'entrée, la valeur de la résistance équivalente créée dans les circuits selon l'invention est déterminable par un courant ou une tension.

Le circuit de polarisation selon l'invention peut fonctionner avec de très faibles courants continus. En dimensionnant les transistors du circuit de façon appropriée, on peut réduire au minimum les pertes ohmiques due à la partie réelle de l'admittance vue par la tension d'entrée à la fréquence de travail. Cette propriété est particulièrement intéressante dans le circuit de la figure 13 et d'une façon plus générale dans les oscillateurs à quartz dans lesquels les pertes peuvent être particulièrement nuisibles sur le plan de la consommation et de la stabilité en fréquence.

Etant donné que dans le circuit selon l'invention, on évite la présence d'une résistance ohmique de valeur élevée, on obtient un gain de place sur le circuit intégré d'autant plus importante que la résistivité dans le circuit est faible.

En outre, on a pu constater que la capacité globale à la masse du circuit selon l'invention incorporé dans un circuit intégré peut être plus faible que la capacité parasite d'un circuit utilisant une résistance ohmique faite dans une couche résistive.

On a vu également que l'on peut programmer la forme de la courbe de transfert du composant actif formant la résistance équivalente en modifiant de façon adéquate les valeurs des capacités du diviseur capacitif 13. En outre la pente de cette caractéristique est peu dépendante des courants présents dans les composants du montage.

Enfin, le circuit a un comportement en fréquence favorable, car le décalage du niveau continu de la tension de sortie est indépendant de la fréquence pour autant que celle-ci dépasse une limite inférieure prédéterminée.

## Revendications

1. Circuit de polarisation destiné à déterminer le niveau moyen d'une tension alternative comprenant le montage en série d'un élément capacitif (C) et d'un composant actif (M10; M12; M19; M20; M24) formant résistance équivalente, une source de courant continu (12; Iₚ₁, Iₚ₂, M17, M18; Iₚ₁, Iₚ₂, M21, M22) raccordée à ce composant actif et des moyens (M11, 11; M13, M14, M15, 11) pour ajuster la conductance dudit composant actif et fixer le niveau moyen de ladite tension alternative, celle-ci (U_{ac}) étant appliquée aux bornes de ce montage en série, tandis que la tension polarisée ayant ledit niveau moyen voulu (Uₒᵤₜ) est prélevée sur le noeud (10) entre ledit élément capacitif (C) et ledit composant actif, ce circuit étant caractérisé en ce qu'il comprend également des moyens de modulation (13) pour moduler le courant continu (i) traversant ledit composant actif (M10; M12; M19; M20; M24) avec une fraction de ladite tension alternative à polariser.

2. Circuit suivant la revendication 1, caractérisé en ce que lesdits moyens de modulation comprennent un diviseur capacitif (C1, C2) dont le point milieu est raccordé à l'une des bornes dudit composant actif (M10; M12; M19; M20; M24).

3. Circuit suivant l'une quelconque des revendication précédentes, caractérisé en ce que ledit composant actif est un transistor MOS (M10; M12; M19; M20; M24).

4. Circuit suivant la revendication 3, lorsqu'elle dépend de la revendication 2, caractérisé en ce que ledit point milieu dudit diviseur (13) est raccordé à la grille dudit transistor (M10; M24) et en ce que la tension alternative (U_{ac}) est appliquée à la source dudit transistor.

5. Circuit suivant la revendication 3, prise en combinaison avec la revendication 2, caractérisé en ce que ledit point milieu du diviseur (13) est raccordé à la source dudit transistor (M12; M19; M20) et en ce que ladite tension alternative (U_{ac}) est appliquée à la grille dudit transistor.

6. Circuit suivant l'une quelconque des revendications précédentes, caractérisé en ce que ledit montage en série dudit élément capacitif (C) et dudit élément actif (M10; M12; M19; M20; M24) comprend également une source (11) d'une tension de référence.

7. Circuit suivant l'une quelconque des revendications précédentes, caractérisé en ce que ladite source de courant comprend un miroir de courant (M14, M15; M17, M18).

8. Circuit suivant l'une quelconque des revendications précédentes, caractérisé en ce que ledit élément capacitif est connecté en amont (C) ou en aval (Ca) desdits moyens de modulation (13) vis-à-vis de l'application de ladite tension à polariser (U_{ac}).

## Claims

1. A bias circuit intended to determine the mean level of an AC voltage comprising the series arrangement of a capacitive element (C) and an active component (M10; M12; M19; M20; M24) forming an equivalent resistor, a DC current source (12; Iₚ₁, Iₚ₂, M17, M18; Iₚ₁, Iₚ₂, M21, M22) joined to this active component and means (M11, 11, M13, M14, M15, 11) for altering the conductance of said active component and fixing the mean level of said AC voltage, the latter (U_{ac}) being applied to the terminals of this series arrangement, whereas the biased voltage having said desired mean level (Uₒᵤₜ) is tapped off from the node (10) between said capacitive element (C) and said active component, this circuit being one which also comprises means of modulation (13) for modulating the DC current (i) passing through said active component (M10; M12; M19; M20; M24) with a fraction of said AC voltage to be biased.

2. The circuit as claimed in claim 1, wherein said means of modulation comprise a capacitive divider (C1, C2) whose middle point is joined to one of the terminals of said active component (M10; M12; M19; M20; M24).

3. The circuit as claimed in either one of the preceding claims, wherein said active component is a MOS transistor (M10; M12; M19; M20; M24).

4. The circuit as claimed in claim 3, when the latter depends on claim 2, wherein said middle point of said divider (13) is joined to the gate of said transistor (M10; M24) and wherein the AC voltage (U_{ac}) is applied to the source of said transistor.

5. The circuit as claimed in claim 3, taken in combination with claim 2, wherein said middle point of the divider (13) is joined to the source of said transistor (M12; M19; M20) and wherein said AC voltage (U_{ac}) is applied to the gate of said transistor.

6. The circuit according to any one of the preceding claims, wherein said series arrangement of said capacitive element (C) and said active element (M10; M12; M19; M20; M24) also comprises a source (11) of a reference voltage.

7. The circuit as claimed in any one of preceding claims, wherein said current source comprises a current mirror (M14, M15; M17, M18).

8. The circuit as claimed in any one of the preceding claims, wherein said capacitive element is connected upstream (C) or downstream (Ca) of said means of modulation (13) in relation to the application of said voltage to be biased (U_{ac}).

## Patentansprüche

1. Vorspannungsschaltung zum Bestimmen des mittleren Pegels einer Wechselspannung, mit einer Reihenschaltung aus einem kapazitiven Element (C) und einem aktiven Element (M10; M12; M19; M20; M24), das einen Ersatzwiderstand bildet, einer Gleichstromquelle (12; Iₚ₁, Iₚ₂, M17, 18; Iₚ₁, Iₚ₂, M21, M22), die an dieses aktiven Element angeschlossen ist, und Mitteln (M11, 11; M13, M14, M15, 11) zum Einstellen des Leitwertes des aktiven Elementes und zum Festlegen des mittleren Pegels der Wechselspannung, wobei diese (U_{ac}) an die Kontakte der Reihenschaltung angelegt wird, während die vorgespannte Spannung, die diesen erwünschten mittleren Pegel (Uₒᵤₜ) hat, an dem Knoten (10) zwischen dem kapazitiven Element (C) und dem aktiven Element abgegriffen wird, wobei diese Schaltung dadurch gekennzeichnet ist, daß sie ferner Modulationsmittel (13) zum Modulieren des das aktive Element (M10; M12; M19; M20; M24) durchfließenden Gleichstroms (i) mit einem Bruchteil der vorzuspannenden Wechselspannung aufweist.

2. Schaltung nach Anspruch 1, dadurch gekennzeichnet, daß die Modulationsmittel einen kapazitiven Teiler (C1, C2) aufweisen, dessen Mittelpunkt an einer der Kontakte des aktiven Elementes (M10; M12; M19; M20; M24) angeschlossen ist.

3. Schaltung nach einem der vorhergehenden Ansprüche, dadurch gekennzeichnet, daß das aktive Element ein MOS-Transistor (M10; M12; M19; M20; M24) ist.

4. Schaltung nach Anspruch 3 in Verbindung mit Anspruch 2, dadurch gekennzeichnet, daß der Mittelpunkt des Teilers (13) an das Gate des Transistors (M10; M24) angeschlossen ist und daß die Wechselspannung (U_{ac}) an die Source des Transistors angelegt ist.

5. Schaltung nach Anspruch 3 in Verbindung mit Anspruch 2, dadurch gekennzeichnet, daß der Mittelpunkt des Teilers (13) an der Source des Transistors (M12; M19; M20) angeschlossen ist und daß die Wechselspannung (U_{ac}) an das Gate des Transistors angelegt wird.

6. Schaltung nach einem der vorhergehenden Ansprüche, dadurch gekennzeichnet, daß die Reihenschaltung aus dem kapazitiven Element (C) und dem aktiven Element (M10; M12; M19; M20; M24) ferner eine Referenzspannungsquelle (11) aufweist.

7. Schaltung nach einem der vorhergehenden Ansprüche, dadurch gekennzeichnet, daß die Stromquelle einen Stromspiegel (M14, M15; M17, M18) aufweist.

8. Schaltung nach einem der vorhergehenden Ansprüche, dadurch gekennzeichnet, daß das kapazitive Element vor (C) oder nach (Ca) dem Modulationsmittel (13) bezogen auf den Punkt, an dem die vorzuspannende Spannung (U_{ac}) angelegt wird, angeschlossen ist.
